# EUROPÄISCHE PATENTSCHRIFT

(11) **EP 0 658 811 B1**
(45) Veröffentlichungstag und Bekanntmachung des Hinweises auf die Patenterteilung: **17.06.1998**
(21) Anmeldenummer: 94116703.3
(22) Anmeldetag: 22.10.1994
(51) Int. Cl.: G03F 7/20

(54) **Beleuchtungseinrichtung für eine Projektions-Mikrolithographie-Belichtungsanlage**
Illumination device for a microlithographic projection exposure apparatus
Dispositif d'illumination pour un appareil pour un appareil d'exposition microlithographique par projection

(30) Priorität: 13.12.1993 DE 4342424; 17.06.1994 DE 9409744 U
(43) Veröffentlichungstag der Anmeldung: 21.06.1995
(73) Patentinhaber: Carl Zeiss, D-89518 Heidenheim (Brenz) (DE)
(72) Erfinder: Wangler, Johannes, D-89551 Königsbronn (DE); Ittner, Gerhard, D-73447 Oberkochen (DE)

(56) Entgegenhaltungen:
- EP-A- 0 297 161
- EP-A- 0 486 316

## Beschreibung

Die Erfindung betrifft eine Beleuchtungseinrichtung für eine Projektions-Mikrolithographie-Belichtungsanlage für die wahlweise Bereitstellung verschiedener Beleuchtungsarten.

Aus EP 0 486 316, EP 0 496 891, EP 0 500 393 und US 5 208 629 sind derartige Beleuchtungseinrichtungen für die symmetrische schiefe Beleuchtung mit zwei oder vier Lichtbündeln bekannt. Es sind jeweils Verstellmöglichkeiten vorgesehen: Bei EP 0 486 316 ist die Geometrie der Quadrupolbeleuchtung verstellbar durch verstellbare Lichtleiter (Fig. 12, 13) oder Linsen (Fig. 17) oder Linsenarrays (Fig. 35) und Fig. 38 zeigt die Anordnung verschiedener Linsenraster auf einem Revolver, mit zwei und vier Lichtbündeln und konventionellem einfachen Lichtbündel. Letzteres ist auch bei EP 0 496 891 Anspruch 13 vorgesehen. Nach Anspruch 12 sind Winkel und Abstand der Quadrupolbeleuchtung einstellbar und in Anspruch 14 ist ein umschaltbarer elektrooptischer Filter zur Darstellung der verschiedenen Beleuchtungsarten angegeben. Auch EP 0 500 393 hat in Figur 16 einen Revolver für verschiedene Beleuchtungsarten.

Die genannten EP-Schriften sehen vor, das von einem einzigen Kollektor erfaßte Licht einer Lichtquelle mit bekannten Mitteln in 1, 2 oder 4 Lichtflüsse aufzuteilen, um die gewünschte Zahl sekundärer Lichtquellen zu erhalten.

Lediglich EP 0 500 393 sieht alternativ die Anordnung von zwei Lampen (Fig. 12) vor. Die Lichtflecke sind stets kreisförmig oder quadratisch. US 5 208 629 Fig. 80 sieht auch vier partiell ringförmige sekundäre Lichtquellen vor, ohne über deren Erzeugung oder Verstellung etwas anzugeben.

EP 0 297 161 erfaßt das Licht einer Lichtquelle mit zwei gegenüberliegenden Kollektoren und leitet es über Spiegel in die Pupillenebene. Verstellmöglichkeiten und andere als konventionelle Beleuchtung sind nicht vorgesehen. Die Anordnung weist einen Glasstab auf und ein spezielles Filter, das wahlweise unmittelbar am Reticle oder am Ausgang des Glasstabs angeordnet werden kann.

In keiner der oben genannten Schriften ist von der Möglichkeit des Scanning bei der Belichtung die Rede, mit Ausnahme der US-Schrift, wo die Ansprüche 16 und 62 eine rotierende schiefe Beleuchtung - mit einem rotierenden Lichtfleck - vorsehen.

Derartiges ist auch in S. T. Yang et al. SPIE 1264 (1990), Seiten 477-485 vorgesehen und in US 3 770 340 für kohärente (Laser-) Beleuchtung und beliebige Abbildungen beschrieben.

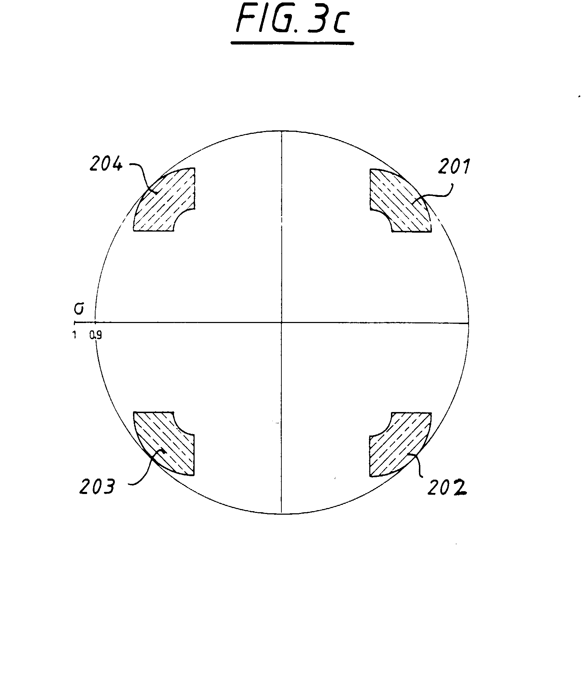

Eine Beleuchtungseinrichtung für die Mikrolithographie nach EP 0 266 203 sieht die Aufspaltung des Lichts einer Lichtquelle in mehrere Lichtflüsse, deren simultanes Scanning, und die gegenseitige Überlagerung vor (Abstract, Anspruch 1). Dies dient der Unterdrückung von Störungen durch kohärentes Licht (vgl. Anspruch 2). Die Aufspaltung in Lichtflüsse erfolgt verlustarm durch geometrische Strahlenteilung (Fig. 4a-d).

Aufgabe der Erfindung ist die Bereitstellung einer Beleuchtungseinrichtung für eine Projektions-Mikrolithographie-Belichtungsanlage für die wahlweise Bereitstellung beliebig vieler verschiedener Beleuchtungsarten einschließlich konventioneller Beleuchtung mit einstellbarem Kohärenzfaktor σ, Ringaperturbeleuchtung und symmetrischer schiefer Beleuchtung aus zwei oder vier Richtungen, die bei großer Universalität hohen Wirkungsgrad bei der Ausnutzung der Lichtquelle mit guter Veränderbarkeit ohne Austausch von Teilen vereinigt und eine gute Abbildungsqualität ermöglicht.

Gelöst wird diese Aufgabe durch eine Beleuchtungseinrichtung, in der alle Merkmale des Anspruchs 1 kombiniert sind. Zum einen kann dadurch auf wechselbare optische Elemente in Schiebern, Revolvern oder dergleichen verzichtet werden, die ohnehin nur eine eng begrenzte Auswahl zulassen oder extensive Umbauarbeiten erfordern, zum andern wird die Lichtquelle für alle Beleuchtungsarten gut ausgenutzt.

Vorteilhafte Ausführungsformen sind Gegenstand der Ansprüche 2-9. Die Ringsegmentform der Lichtflüsse erlaubt schon durch rein radiales Verstellen außer einer exakten Ringaperturbeleuchtung bei engerer Stellung die klassische Beleuchtung, eventuell mit einer kleinen "central obscuration", bei teilweise in der Pupillenebene überlappenden Lichtflüssen und bei weiter Stellung die symmetrische schiefe Beleuchtung. Letztere wird zwar üblicherweise mit kreisförmigen sekundären Lichtquellen gemacht, die Form spielt aber im Detail keine Rolle, vgl. US 5 208 629 mit partiell ringförmigen sekundären Lichtquellen.

Als Lichtquelle ist auch ein Laser geeignet, der mit einem Strahlteiler kombiniert wird.

Näher erläutert wird die Erfindung anhand der Zeichnung.
- Fig. 1a: zeigt schematisch ein Ausführungsbeispiel einer erfindungsgemäßen Beleuchtungseinrichtung seitlich;
- Fig. 1b: zeigt dasselbe in Aufsicht;
- Fig. 1c: zeigt den Querschnitt der Austrittsflächen der Lichtleiter der Figur 1a und b;
- Fig. 2: zeigt schematisch ein anderes Ausführungsbeispiel;
- Fig. 3: zeigt die sekundären Lichtquellen in der Pupillenebene des Zwischenabbildungssystems
a) konventionell,
b) Ringapertur
c) Quadrupol.

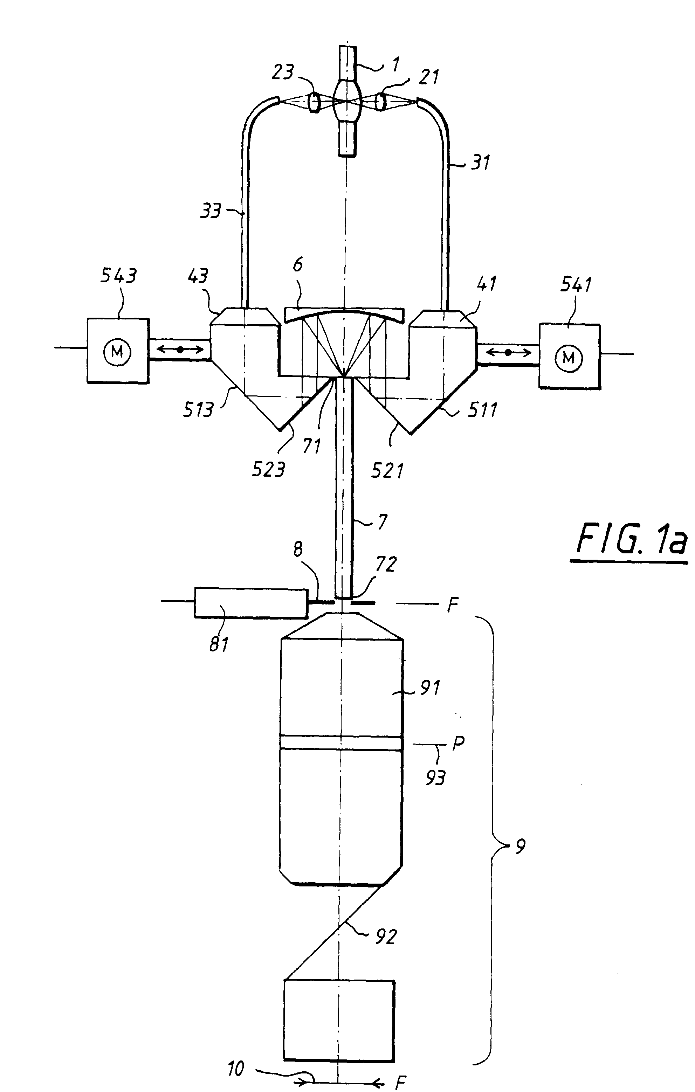

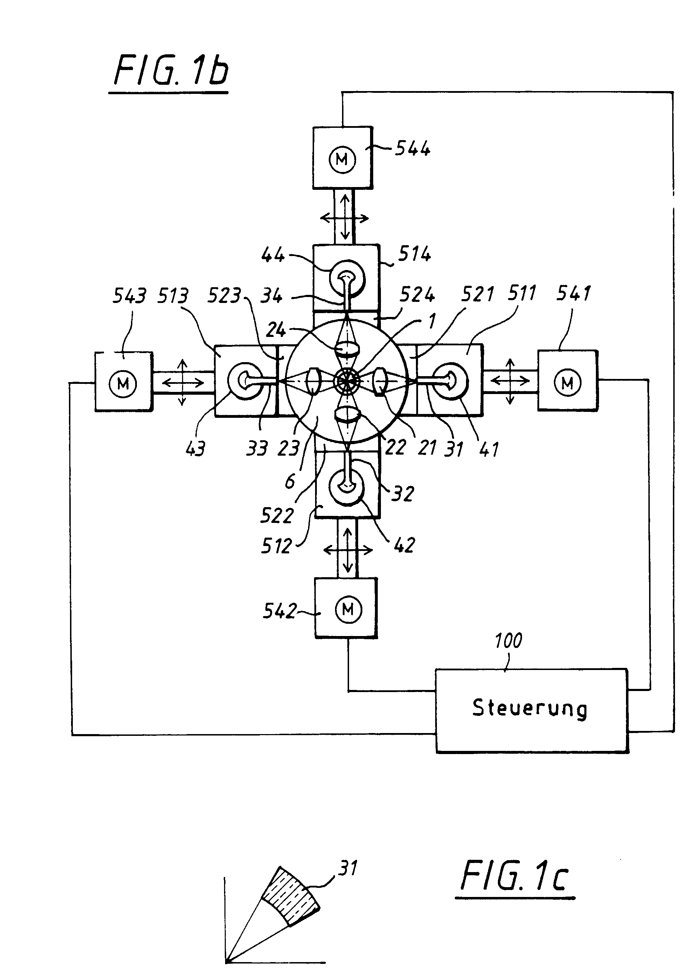

In Figur 1a) und in Figur 1b) ist eine Quecksilber-Kurzbogenlampe als Lichtquelle (1) dargestellt, von deren Lichtfluß vier Kollektoren (21-24) jeweils einen großen Raumwinkelbereich erfassen, so daß ein Großteil des Lichts den vier Lichtleitern (31-34) zugeführt wird. Die Lichtleiter (31-34) sind als Querschnittswandler ausgebildet, deren Austrittsflächen ringsegmentförmig sind, wie in Figur 1c) dargestellt. Zur weitgehenden Homogenisierung der Lichtintensität über die Austrittsflächen sind die Lichtleiter (31-34) z.B. aus statistisch durchmischten Einzelfasern zusammengesetzt. Auch kann ihr Eingangsquerschnitt an die Lichtverteilung angepaßt sein.

Alternativ kann die Beleuchtung der Lichtleiter (31-34) auch durch einen Laser mit Strahlaufweitungsoptik und Pyramidenspiegel als geometrischen Strahlteiler realisiert werden. Der Laser ist dann z.B. ein im UV emittierender Excimer-Laser.

An die Austrittsflächen der vier Lichtleiter (31-34) schließen sich je eine Einheit aus einer Relaisoptik (41-44), einem ersten Umlenkspiegel (511-514) und einem zweiten Umlenkspiegel (521-524) an. Diese Einheiten einschließlich der verbundenen Enden der flexibel ausgeführten Lichtleiter (31-34) sind durch Stellantriebe (541-544) jeweils radial und azimutal verstellbar bzw. scanbar. Eine Steuerung (100) kontrolliert die Stellantriebe (541-544).

Über den Einkoppelspiegel (6) wird das von den vier Umlenkspiegeln (521-524) kommende Licht auf die Eintrittsfläche (71) eines Glasstabs (7) abgebildet. Diese Eintrittsfläche (71) liegt in einer Pupillenebene P der Beleuchtungsanordnung und jede der vier Einheiten kann je nach Stellung der Stellantriebe (541-544) jeweils Teile eines Quadranten dieser Eintrittsfläche ausleuchten. Die vier von den Kollektoren (21-24) erfaßten Lichtströme werden also hier geometrisch zusammengesetzt zu einer effektiven sekundären Lichtquelle.

Bei der Austrittsfläche (72) des Glasstabs (7) befindet sich eine Feldebene F in der ein Reticle-Masking-System (8), also eine verstellbare Blende, angeordnet ist. Mit dem Stellmittel (81) wird das Reticle-Masking-System bedarfsgemäß verstellt.

Das Reticle-Masking-System (8) an dieser Stelle erspart gegenüber bekannten Lösungen den Aufwand für die Bereitstellung einer zusätzlichen Feldebene nur für das Reticle-Masking-System.

Das folgende Zwischenabbildungssystem (9) ist ein Objektiv mit einer Pupillenebene P (93), davor dem Inter-Masking-System (91) und danach einer symbolisch dargestellten Strahlumlenkung (92), bestehend aus einem Planspiegel, welcher in bekannter Weise einen kompakteren Gesamtaufbau ermöglicht. Es folgt das zu beleuchtende Reticle (10) in der Feldebene F.

Das folgende Projektionsobjektiv und der zu belichtende Wafer sind bekannt und nicht dargestellt.

Numerische Apertur und Abbildungsmaßstab des Projektionsobjektivs bzw. die Größe seiner Pupille sind jedoch für die geometrischen Daten der Beleuchtungseinrichtung entscheidend und legen dessen erforderlichen Bereich der numerischen Apertur fest.

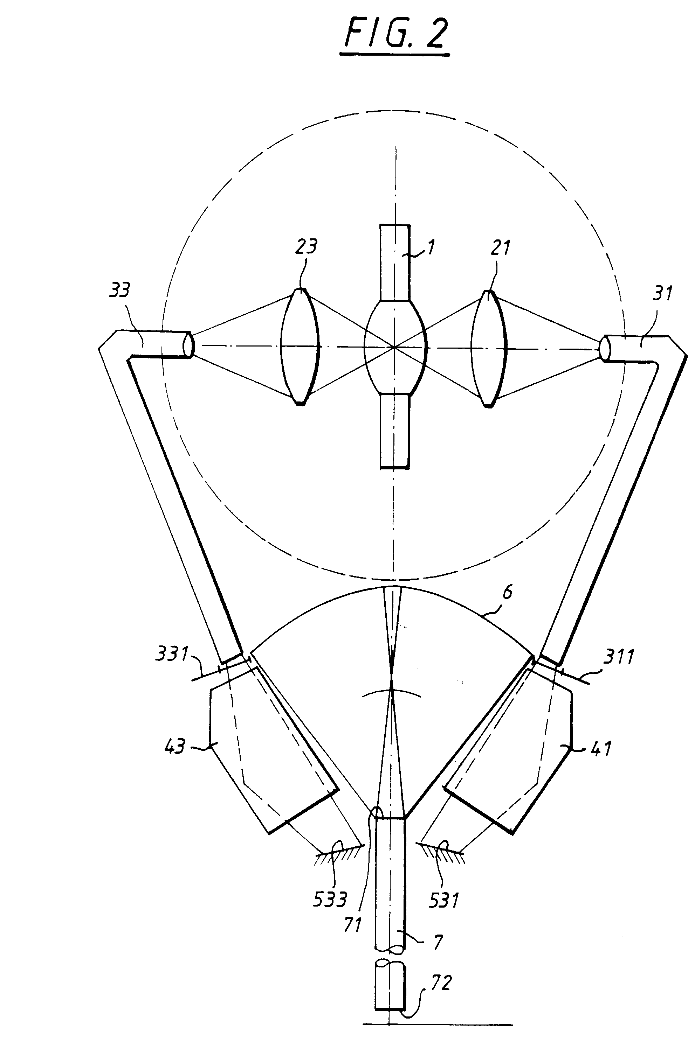

Figur 2 zeigt ein anderes Ausführungsbeispiel der vor dem Glasstab (7) angeordneten Baugruppe. Lichtquelle (1) und Kollektoren (21, 23) sind wie oben ausgeführt. Die Lichtleiter (31, 33) sind starr, z.B. Glasstäbe. An ihrem Ende sind Verschlüsse (311, 331) vorgesehen, danach folgen Relaisoptiken (41, 43).

Die Scanspiegel (531, 533) sind am Ort der Hinterblende der Relaisoptiken (41, 43) angeordnet und sind einteilig, klein und leicht.

Die Scanspiegel (531, 533) sind um die Symmetrieachse der Anordnung, d.h. die optische Achse des Glasstabs (7), azimutal drehbar und um ihre zur Zeichenebene senkrechte Mittelachse kippbar. Ein Einkoppelspiegel (6) mit bedarfsweise gestalteten Quadranten dient wiederum zur Abbildung auf die Eintrittsfläche (71) des Glasstabs (7).

Durch die kleine und leichte Bauart der Scanspiegel (531, 533) eignen sich diese besonders für ein schnelles Scanning. Die Antriebseinheiten dafür sind nicht dargestellt, ihre Ausführung ist bekannt.

Zu den dargestellten zwei Gruppen für die Erzeugung von zwei sekundären Lichtquellen können analog Figur 1a und b zwei weitere Gruppen um 90° um die optische Achse gedreht angeordnet werden. Die Form der sekundären Lichtquellen wird dem Bedarf entsprechend festgelegt und durch die Form der Lichtleiter (31, 33) erzeugt.

Die erfindungsgemäße Beleuchtungseinrichtung nach den Beispielen der Figur 1 und Figur 2, aber auch vielfältige Abwandlungen dieser Beispiele, hat als entscheidende Eigenschaft, daß in der Pupillenebene (93) des Zwischenabbildungssystems (9) sekundäre Lichtquellen unterschiedlichster Form und Dimension erzeugt werden können, und zwar in Kombination der in jedem Quadranten (oder bei nur zwei Teilsystemen in jedem Halbkreis) bereitgestellten und am Ausgang der Lichtleiter (31-34) erzeugten Form (insbesondere Ringsegmentform) des Lichtflusses verbunden mit der radialen und azimutalen Verstellung, die durch die Steuerung (100) beliebig eingestellt werden kann.
Die Verstellung kann dabei auch während der Belichtung erfolgen (Scanning).
Ohne jeden Austausch oder Umbau von Teilen können somit beliebig viele unterschiedliche Beleuchtungsarten mit stetiger verstellung der Parameter erzeugt werden, wodurch die Beleuchtungseinrichtung z. B. auch zur experimentellen Optimierung des Belichtungsverfahrens besonders geeeignet ist.

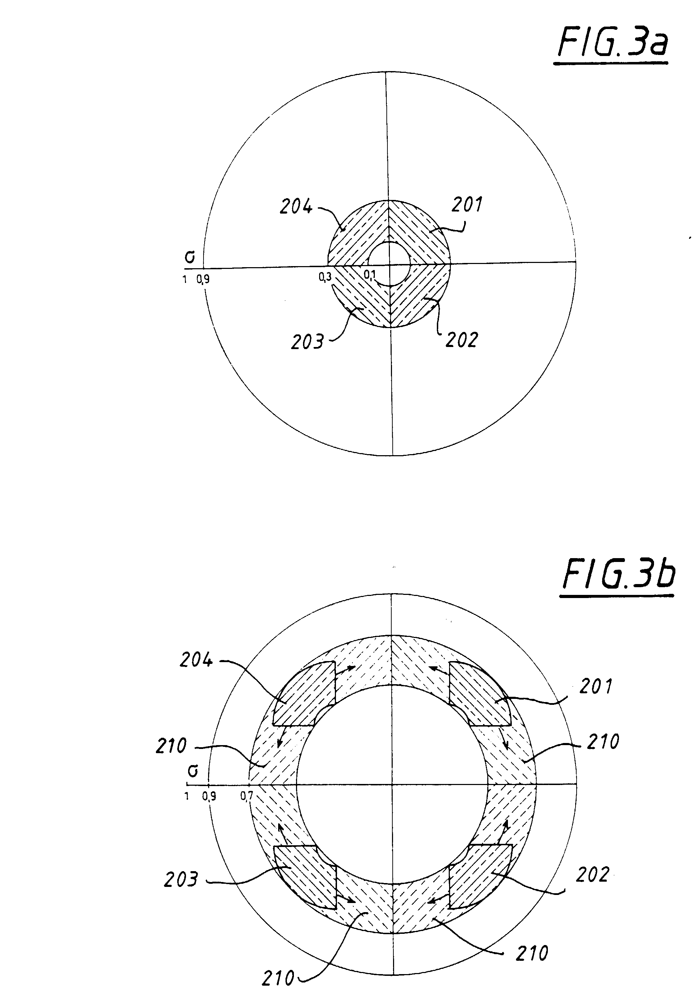

In Figur 3a-c) sind dafür Beispiele angegeben. Die Bilder zeigen die Lichtbündel in der Pupillenebene (93). Angegeben ist der relative Radius σ bezogen auf den Radius der Pupille des Projektionsobjektivs unter Berücksichtigung des Abbildungsmaßstabs. σ wird auch als Kohärenzgrad der Beleuchtung bezeichnet.

Figur 3a zeigt eine klassische Beleuchtung mit dem relativ geringen σ = 0,3 und einer "central obscuration" von 0,1. Die zentrale Abschattung ist vielfach gewollt, um zentral Justier- und Meßstrahlengänge anordnen zu können.

Die sekundäre Lichtquelle setzt sich aus den Anteilen der vier Quadranten zusammen, in denen jeweils ringsegmentförmige Lichtflecke (201-204) mit innerem Radius entsprechend σ = 0,1 und äußerem Radius entsprechend σ = 0,3 sowie mit Azimutwinkel 90° als Bilder der entsprechend geformten Enden der Lichtleiter (31-34) liegen. Ohne eine Scanbewegung wird so unmittelbar eine konventionelle Beleuchtung erzeugt, bei der viel Licht von der Lichtquelle (1) erfaßt wird und nichts davon unnötig ausgeblendet wird.

Figur 3b zeigt in gleicher Darstellung wie Figur 3a eine Ringaperturbeleuchtung. Die gleichen Lichtflecke (201-204) sind nun radial nach außen verschoben und werden azimutal gescant, d.h. während der Belichtungszeit über ihren jeweiligen Quadranten hinwegbewegt, so daß im zeitlichen Mittel eine Ringaperturbeleuchtung, deren azimutale Homogenität durch den Verlauf der Scanbewegung beeinflußbar ist, erzeugt wird.

Es ist sofort ersichtlich, daß durch Kombination der Beleuchtung nach Figur 3a und 3b z.B. eine klassische Beleuchtung mit großem σ, z.B. 0,5 bis 0,7 erreicht werden kann, wenn eine radiale Verstellung und ein azimutaler Scan innerhalb der Belichtungszeit kombiniert werden. Auch eine Ringaperturbeleuchtung mit größerer Differenz zwischen innerem und äußerem Radius wird so möglich.

Figur 3c ist ein Beispiel für die symmetrische schiefe Beleuchtung, ausgeführt als Quadrupolbeleuchtung. In ihrer einfachsten Form geht diese aus der Ringaperturbeleuchtung Figur 3b durch weglassen der Azimutalbewegung hervor. Typisch werden hier randnahe Lichtflecke (größtes σ ≈ 0,9) benötigt. Die genaue Form der Lichtflecke ist bei der Quadrupolbeleuchtung nicht erheblich (vgl. US 5 208 629). Größe und auch die Form der Quadrupol-Lichtflecke können jedoch durch radiale und azimutale Bewegung während der Belichtungszeit dem Bedarf angepaßt werden.

Hingewiesen sei auch auf die Möglichkeit, verlustfrei eine Dipolbeleuchtung zu realisieren, indem je zwei benachbarte Lichtflecke (201, 202) und (203, 204) azimutal an die Grenze der Quadranten gestellt werden und sich so vereinigen.

Die gezeigte Form der Lichtflecke (201-204) ist ein vorteilhaftes Ausführungsbeispiel, sie kann beliebig abgewandelt werden. Es ist auch möglich, ihre Form durch zusätzliche Blenden, insbesondere mit den Verschlüssen (311-341) vereinigt, zu beeinflussen, obwohl dadurch Lichtverluste hingenommen werden müssen.

Die Ringsegmentform ist der Geometrie der Beleuchtungseinrichtung besonders angepaßt, da sie bei dem mittleren Radius der sekundären Lichtquelle, der zugleich der mittlere Radius der Ringsegmente ist, exakt gleichmäßige radiale Lichtverteilung im Lichtfleck ergibt. Auch bei anderer Lage ist die Lichtverteilung noch gleichmäßiger als z.B. mit einem gescanten runden Fleck (der nicht sehr klein ist). Auch kann dann eine klassische Beleuchtung ohne Scanning exakt realisiert werden.

Als Lichtmischeinrichtung eignet sich bei einer erfindungsgemäßen Anordnung ein Glasstab (7) besser als ein Wabenkondensor, da sein enger Querschnitt eine kompaktere Bauform erlaubt, vgl. Fig. 2, wo die Scan-Spiegel (531, 533) neben dem Glasstab (7) angeordnet sind.

Zur Kompaktheit bei guter Qualität trägt es auch bei, wenn ein Reticle-Masking-System (8) nicht wie üblich in einer extra dafür geschaffenen Zwischen-Feldebene angeordnet ist, sondern in der Feldebene unmittelbar hinter dem Glasstab (7) realisiert ist.

Die Steuerung (100) für die Stelltriebe (541-544) der radialen und azimutalen Bewegung wird zweckmäßig in die Steuerung bekannter Art des Gesamtsystems integriert und generiert programmgesteuert abhängig von der Strukturierung des jeweiligen Reticles die vorgegebenen optimalen Abläufe der Erzeugung der sekundären Lichtquellen.

## Patentansprüche

1. Beleuchtungseinrichtung für eine Projektions-Mikrolithographie-Belichtungsanlage für die wahlweise Bereitstellung verschiedener Beleuchtungsarten, und zwar beliebig vieler einschließlich konventioneller Beleuchtung mit einstellbarem Kohärenzfaktor (σ), Ringaperturbeleuchtung und symmetrischer schiefer Beleuchtung aus zwei oder vier Richtungen
- mit einer Lichtquelle (1),
- mit Mitteln (21-24) zum getrennten Erfassen von Lichtflüssen aus zwei oder vier Raumwinkelbereichen des von der Lichtquelle (1) emittierten Lichtflusses,
- mit Mitteln (31-34) zum Formen oder Ausblenden der erfaßten Lichtflüsse,
- mit einer Spiegelanordnung (511-514, 521-524, 531, 533; 6) zur Abbildung der Lichtflüsse auf Sektoren einer Pupillenebene (93), die fouriertransformiert zur Reticleebene für das abzubildende Reticle (10) ist,
- mit Verstellmitteln (541-544) für jeden einzelnen Lichtfluß derart, daß die Bilder der Lichtflüsse in der Pupillenebene (93) radial und azimutal beliebig verschoben werden können.

2. Beleuchtungseinrichtung nach Anspruch 1, dadurch gekennzeichnet, daß die Mittel zum Erfassen (21-24) oder die Mittel zum Formen (31-34) oder Ausblenden der erfaßten Lichtflüsse Lichtleiter (31-34) enthalten.

3. Beleuchtungseinrichtung nach Anspruch 2, dadurch gekennzeichnet, daß die Verstellmittel (541-544) die Lage der Ausgänge der Lichtleiter (31-34) verstellen.

4. Beleuchtungseinrichtung nach Anspruch 1, dadurch gekennzeichnet, daß die Verstellmittel (541-544) Teile der Spiegelanordnung (511-533) verstellen.

5. Beleuchtungseinrichtung nach mindestens einem der Ansprüche 1-4, dadurch gekennzeichnet, daß zwischen der Spiegelanordnung (511-533, 6) und der Reticleebene (10) ein Glasstab (7) angeordnet ist.

6. Beleuchtungseinrichtung nach Anspruch 5, dadurch gekennzeichnet, daß nahe dem Austrittsende (72) des Glasstabs (7) ein variables Maskierungssystem (8) angeordnet ist.

7. Beleuchtungseinrichtung nach mindestens einem der Ansprüche 1-6, dadurch gekennzeichnet, daß die Bilder der Lichtflüsse in der Pupillenebene (93) so dimensioniert sind, daß sie ohne Scanningbewegung geeignet sind für die symmetrische schiefe Beleuchtung oder für die konventionelle Beleuchtung mit einem Kohärenzfaktor von σ = 0,1 oder größer.

8. Beleuchtungseinrichtung nach mindestens einem der Ansprüche 1-7, dadurch gekennzeichnet, daß Mittel zum Verändern der Größe der Bilder der Lichtflüsse in der Pupillenebene vorgesehen sind.

9. Beleuchtungseinrichtung nach mindestens einem der Ansprüche 1-8, dadurch gekennzeichnet, daß Mittel zum Verändern der Form der Lichtflüsse vorgesehen sind.

10. Beleuchtungseinrichtung nach mindestens einem der Ansprüche 1-9, dadurch gekennzeichnet, daß die Lichtflüsse in Ringsegmentform gebracht werden.

11. Beleuchtungseinrichtung nach mindestens einem der Ansprüche 1-10, dadurch gekennzeichnet, daß die Lichtquelle ein Laser ist und die Mittel zum getrennten Erfassen von Lichtflüssen einen Strahlteiler enthalten.

12. Beleuchtungseinrichtung nach mindestens einem der Ansprüche 1-11, dadurch gekennzeichnet, daß die Verstellmittel (541-544) zur Bereitstellung einer bestimmten Beleuchtungsart während jedes Belichtungsvorgangs eine Scanningbewegung ausführen, so daß seriell ein Bild der Lichtflüsse in der Pupillenebene (93) erzeugt wird.

## Claims

1. Illumination apparatus for a microlithographic projection exposure system for the selective provision of various illumination modes namely voluntarily many modes including conventional illumination with definable coherence factor (σ), ring aperture illumination and symmetrical off-axis illumination from two or four directions
- with a light source (1),
- with means (21-24) for the separate reception of light fluxes from two or four spatial angle regions of the light flux which is emitted by the light source (1),
- with means (31-34) for forming or limiting the received light fluxes,
- with a mirror arrangement (511-514, 521-524, 531, 533; 6) for imaging the light fluxes onto sectors of a pupil plane (93), which is the fourier transform of the reticle plane for the reticle (10) to be imaged,
- with displacing means (541-544) for each separate light flux such that the images of the light fluxes can be voluntarily shifted radially and azimuthally in the pupil plane (93).

2. Illumination apparatus according to claim 1, characterized in that the means (21-24) for reception or the means (31-34) for forming or limiting the received light fluxes contain light guides (31-34).

3. Illumination apparatus according to claim 2, characterized in that the displacing means (541-544) displace the positions of the exits of the light guides (31-34).

4. Illumination apparatus according to claim 1, characterized in that the displacing means (541-544) displace parts of the mirror arrangement (511-533).

5. Illumination apparatus according to at least one of the claims 1-4, characterized in that a glass rod (7) is arranged between the mirror arrangement (511-533; 6) and the reticle plane (10).

6. Illumination apparatus according to claim 5, characterized in that a variable mask system (8) is arranged near the exit end (72) of the glass rod (7).

7. Illumination apparatus according to at least one of the claims 1-6, characterized in that the images of the light fluxes in the pupil plane (93) are dimensioned such that they are suitable for the symmetric off-axis illumination or for the conventional illumination with a coherence factor of σ = 0,1 or more without of a scanning movement.

8. Illumination apparatus according to at least one of the claims 1-7, characterized in that means are provided for changing the magnitude of the images of the light fluxes in the pupil plane.

9. Illumination apparatus according to at least one of the claims 1-8, characterized in that means for changing the shape of the light fluxes are provided.

10. Illumination apparatus according to at least one of the claims 1-9, characterized in that the light fluxes are transformed into ring segment shape.

11. Illumination apparatus according to at least one of the claims 1-10, characterized in that the light source is a laser and the means for separate reception of light fluxes contain a beam splitter.

12. Illumination apparatus according to at least one of the claims 1-11, characterized in that for producing a certain mode of illumination the displacing means (541-544) exert a scanning movement during each process of exposure, so a scanning movement during each process of exposure, so that an image of the light fluxes is produced sequentially in the pupil plane.

## Revendications

1. Dispositif d'éclairage destiné à une installation d'exposition pour la microlithographie par projection et permettant de recourir au choix à un nombre illimité de différents types d'éclairage, y compris l'éclairage classique avec un facteur de cohérence (σ) réglable, un éclairage d'ouverture annulaire et un éclairage oblique symétrique dans deux ou quatre directions, comprenant
- une source de lumière (1),
- des moyens (21-24) pour capter séparément la lumière émise par la source de lumière (1) dans deux ou quatre secteurs angulaires,
- des moyens (31-34) pour la mise en forme ou le diaphragmage des flux lumineux captés,
- un ensemble de miroirs (511-514, 521-524, 531, 533; 6) servant à reproduire les flux lumineux sur les secteurs d'un plan de pupille (93) qui est relié par transformation de Fourier au plan du réticule à reproduire (10),
- des moyens de réglage (541-544) de chaque flux lumineux permettant de déplacer librement dans les sens radial et axial les images des flux lumineux dans le plan de pupille (93).

2. Dispositif d'éclairage selon la revendication 1, caractérisé en ce que les moyens pour capter la lumière (21-24) ou les moyens pour mettre en forme (31-34) ou pour diaphragmer les flux lumineux captés comprennent des conducteurs de lumière (31-34).

3. Dispositif d'éclairage selon la revendication 2, caractérisé en ce que les moyens de réglage (541-544) positionnent les sorties des conducteurs de lumière (31-34).

4. Dispositif d'éclairage selon la revendication 1, caractérisé en ce que les moyens de réglage (541-544) agissent sur des éléments de l'ensemble de miroirs (511-533).

5. Dispositif d'éclairage selon l'une au moins des revendications 1 à 4, caractérisé en ce qu'une tige en verre (7) est disposée entre l'ensemble de miroirs (511-533, 6) et le plan du réticule (10).

6. Dispositif d'éclairage selon la revendication 5, caractérisé en ce qu'un système de masquage variable (8) est disposé à proximité de la sortie (72) de la tige en verre (7).

7. Dispositif d'éclairage selon l'une au moins des revendications 1 à 6, caractérisé en ce que les images des flux lumineux dans le plan de pupille (93) sont dimensionnées de manière à se prêter sans mouvement de balayage à l'éclairage oblique symétrique ou à l'éclairage classique avec un facteur de cohérence de σ = 0,1 ou supérieur.

8. Dispositif d'éclairage selon l'une au moins des revendications 1 à 7, caractérisé en ce qu'il comprend des moyens permettant de faire varier la taille des images des flux lumineux dans le plan de pupille.

9. Dispositif d'éclairage selon l'une au moins des revendications 1 à 8, caractérisé en ce qu'il comprend des moyens permettant de faire varier la forme des flux lumineux.

10. Dispositif d'éclairage selon l'une au moins des revendications 1 à 9, caractérisé en ce que les flux lumineux sont mis en forme de manière à présenter un profil en segment d'anneau.

11. Dispositif d'éclairage selon l'une au moins des revendications 1 à 10, caractérisé en ce que la source de lumière est un laser et que les moyens pour capter séparément la lumière émise comprennent un diviseur de faisceau.

12. Dispositif d'éclairage selon l'une au moins des revendications 1 à 11, caractérisé en ce que les moyens de réglage (541-544) exécutent un mouvement de balayage à chaque exposition pour fournir un certain type d'éclairage, de manière à ce qu'une image à composition sérielle des flux lumineux soit formée dans le plan de pupille (93).
